Europäisches Patentamt

European Patent Office

Office européen des brevets

(11) Publication number: **0 320 090**
**A2**

# EUROPEAN PATENT APPLICATION

(21) Application number: 88308371.9

(22) Date of filing: 09.09.88

(51) Int. Cl.4: **H01L 21/304 , B28D 5/00 ,
G02B 3/08**

(30) Priority: 10.12.87 GB 8728879

(43) Date of publication of application:
14.06.89 Bulletin 89/24

(84) Designated Contracting States:
DE FR IT

(71) Applicant: WESTINGHOUSE BRAKE AND
SIGNAL HOLDINGS LIMITED
Pew Hill
Chippenham Wiltshire(GB)

(72) Inventor: Merritt, Giles Roderick
38 Woodlands Park
Calne Wiltshire(GB)
Inventor: Whiting, Gerald
65 Brook Drive
Calne Wiltshire(GB)

(74) Representative: Page, Edmund John et al
PAGE & CO Temple Gate House Temple
Gate
Bristol BS1 6PL(GB)

(54) Shaping silicon semiconductor wafers.

(57) A method of shaping silicon material comprising
mounting the material (1) by a planar face (4) thereof
on a backing (5), rotating the thus mounted material
(1) about an axis (16) passing through the planar
face (4), engaging the material (1) with a diamond-
tipped cutting tool (20) and relatively traversing the
tool (20) and the material (1) such that the tool (20)
is fed into the material (1) to cut silicon from the
material (1).

FIG.2

## Shaping Silicon Semiconductor Wafers

This invention relates to shaping materialfor the manufacture of the likes of semiconductor or optical devices.

It is well known to shape silicon semiconductor wafers by cutting through one or more of the p-n junctions provided by adjacent layers of opposite-type conductivity in a silicon semiconductor wafer. In particular, but not necessarily, such shaping is effected to chamfer the peripheral edge of the wafer to achieve optimum and/or consistent behaviour of the blocking characteristics of high voltage silicon power devices such as diodes, transistors and thyristors.

Silicon material is also used for the fabrication of infra red lenses and, for this purpose, the material requires accurate shaping to a predetermined geometrical shape.

Various techniques have traditionally been employed to effect such shaping - chemical etching, grinding, lapping, sawing (with diamond wheels, slurry-fed wires and reciprocating blades), sandblasting, etc. Such techniques all have a variety of objections. The profile achievable is not the most desirable; the technique is not sufficiently controllable to achieve consistency; the technique is insufficiently precise; residual damage is left in the shaped wafer; or the technique is unduly costly.

Silicon is a particularly brittle material. Indeed, it is by virtue of this characteristic that the employment of diamond-tipped tools have only been used for scoring the wafer surface prior to stress fracturing. It has, hitherto, therefore not been considered practical to use a diamond-tipped tool actually to shape the wafer but, surprisingly, it has now been found that a diamond-tipped tool can, in fact, be used to pare off material from a silicon semiconductor wafer to form the required shape. Thus, by reason of this discovery, silicon material can be shaped to provide profiles of the most desirable contours either hitherto unobtainable or obtainable only with unacceptable lack of consistency.

Accordingly, the present invention provides a method of shaping silicon material comprising mounting the material by a planar face thereof on a backing, rotating the thus mounted material about an axis passing through the planar face, engaging the material with a diamond-tipped cutting tool and relatively traversing the tool and the material such that the tool is fed into the material to cut silicon from the material.

The material may be a wafer having therein a plurality of layers of opposite-type conductivity extending parallel to the opposite planar faces of the wafer and the tool is fed into the wafer to cut through at least one of the p-n junctions provided between the layers of opposite-type conductivity. In this case, the backing may be a molybdenum disc. The wafer may be mounted on the backing by being soldered thereto and, in this case, the solder may be an aluminium/silicon solder. The axis of rotation preferably extends perpendicularly through the planar faces of the wafer.

The material may have opposed planar faces by one of which it is mounted on the backing and the tool is fed into the material from its opposite planar face to form therein a shaped groove constituting in the finished material one of a number a concentric of such grooves thereby forming a Fresnel lens.

It may be the tool which is traversed relative to the wafer.

The diamond of the tip of the tool is preferably of gem-stone quality or high-grade industrial quality. The tool may have a negative rake of less than -7 1·2 degrees and, preferably, -5 degrees and a clearance of less than +10 degrees and, preferably, +7 degrees.

The diamond tip of the tool may be shaped to the required shape of the cut in the wafer to be made by the tool. In this case, the tool may be fed into the wafer in a direction perpendicular to the planar faces of the wafer and the tool may shape the wafer to form a peripheral face to the shaped wafer which is conical and is of larger diameter at the planar face of the wafer adjacent the backing than it is at the opposite planar face of the wafer.

Alternatively, the tool may be fed into the wafer in a direction inclined with respect to the axis of rotation of the wafer and backing. In this case, the tool may shape the wafer to form a peripheral face to the shaped wafer which is conical and is of smaller diameter at the planar face of the wafer adjacent the backing than it is at the opposite planar face of the wafer.

Preferably, the tool is fed with a water-soluble oil-solution coolant.

The backing may be only a temporary backing which is in place during the shaping of the material and is removed thereafter.

The present invention also provides a silicon semiconductor wafer having therein a plurality of layers of opposite-type conductivity shaped by the methods of the present invention.

Embodiments of the present invention will now be described in greater detail, by way of example only, with reference to the accompanying drawing of which:-

Fig. 1 shows a cross-sectional view of the means for mounting the semiconductor wafer ready for shaping,

Fig. 2 shows on an enlarged scale, a wafer being shaped by one form of tool, and

Fig. 3 shown, on the same scale as Fig. 2, a wafer being shaped by another form of tool.

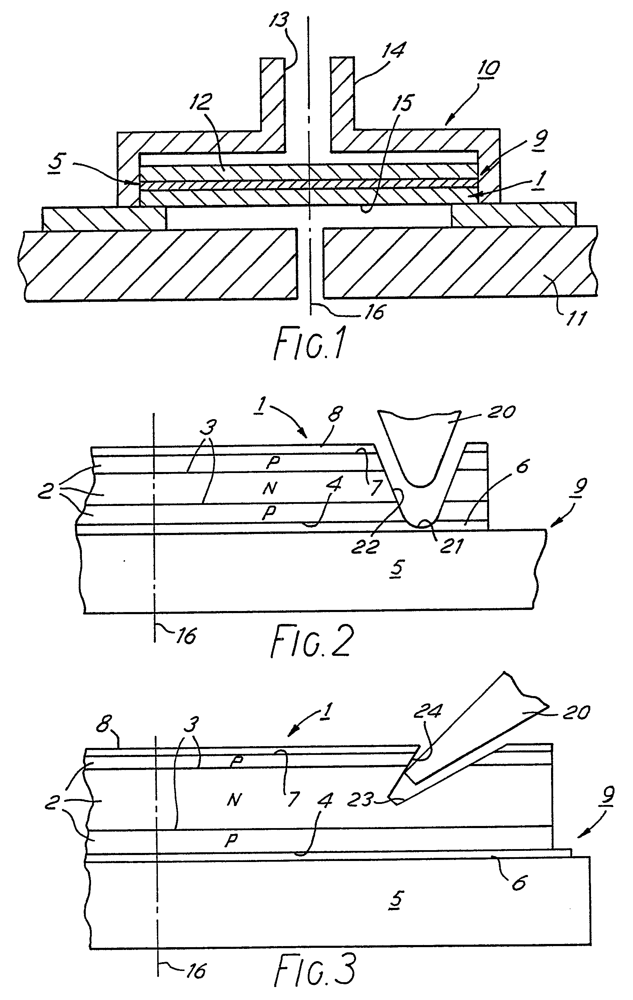

As conventionally (and as shown particularly in Figs. 2 and 3) a silicon semiconductor wafer 1 has therein various p- and n-type conductivity layers 2 providing between adjacent layers p-n junctions 3. The wafer 1 is mounted by one of its opposite major faces (planar face 4), face-to-face, on a backing provided by a molybdenum disc 5, the wafer 1 being secured to that disc 5 by an aluminium/silicon solder layer 6. On the other of its opposite major faces (planar face 7), the wafer 1 has an aluminium contact 8. The sandwich 9 thus provided is a conventional semiconductor sandwich.

This sandwich 9 is mounted in a bell-shaped work-holder 10 (Fig. 1) by the sandwich 9 first being mounted on a vacuum table 11 with the sandwich 9 molybdenum face 5 up. The bell-shaped holder 10 is then mounted on the table 11 surrounding the sandwich 9 as shown in Fig. 1. The vacuum table 11 is then exhausted so that the sandwich 9 and the holder 10 are pulled down onto the table 11. Hot wax 12 is then poured into the holder 10 through the bore 13 in its stem 14. When this wax has set upon its subsequent cooling, the sandwich 9 will firmly be held in the holder 10 with the face 15 of the sandwich 9 truly square to the axis 16 of the holder 10 and sandwich 9.

The thus assembled sandwich 9 and holder 10 are now mounted in a lathe (not shown) with the axis 16 coincident with the axis of the lathe. In Figs. 2 and 3, the holder 10 has been omitted for the purposes of clarity.

The lathe is provided with a diamond-tipped tool 20 of which the diamond is of gem-stone quality or, at least, high-grade industrial quality. The tool is mounted in a conventional lathe tool-carrier by which it can be brought into engagement with the planar face 7 of the wafer 1 and, thereafter, traversed with respect to the wafer 1 to cause the tool 20 to be fed into the wafer 1. The diamond-tipped tool has a negative rake of -5 degrees and a clearance of +7 degrees. With a spindle feed of between 5,200 to 5,600 r.p.m., the feedrate of the tool is 200 to 500 $\mu$/min; i.e. about 35 to 95 mm per cut. In order to reduce heat at the cutting tip and thereby enhance tool life, the tool is fed with a water-soluble oil solution such as is normally used as a grinding fluid for working silicon material. Overheating of the tool, as will an excessive feed-rate, will shorten the tool life.

In the embodiment of Fig. 2, the shape of the diamond tip of the tool 20 is such that when it is fed into the wafer 1 in a direction parallel to the axis 16, it will cut a groove 21 of the same configuration as that of the tip of the tool 20. In this embodiment, this will provide, in the shaped wafer, a peripheral edge 22 which is conical in shape and is of larger diameter where it is adjacent the face 4 than it is where it is adjacent the face 7.

In the embodiment of Fig. 3, the diamond tip of the tool 20 is of different shape than the required groove 23 and the shape of the groove 23 is determined by appropriate directional movement of the tool 20. In this case, the tool has been manipulated to form a peripheral edge 24 which although as in the embodiment of Fig. 2 is of conical shape in this case its larger diameter is adjacent the face 7 of the wafer 1.

From the above described alternative examples of the configuration of the conical peripheral face formed by the shaping of the wafer 1, it can be seen that by suitable shaping of the tip of the tool 20 and appropriate manipulation of the tool 20 any required shape for the peripheral face 23/24 can be achieved.

Again, the above described embodiments have been concerned with the formation of the peripheral face 23/24 of the wafer 1 but, obviously, the same technique in accordance with the present invention can be used to shape any other part of the wafer 1.

After completion of shaping of the wafer 1, the sandwich 9 is removed from the holder 10 by freezing the assembly to, say, -20 degrees C whereupon the sandwich 9 can be "cracked-out" of the holder 10 by passing a plunger through the bore 13.

In the shaping process, the tool 20 may be fed with a suitable lubricant both to cool the tool 20 and the wafer 1 so as to enhance the cutting efficiency of the tool 20.

In the above described embodiment, the wafer 1 is a semiconductor wafer. However, the invention is equally applicable for shaping other semiconductor material.

For example, infra-red lenses are manufactured from silicon material. With the present invention silicon Fresnel lenses can be made by mounting a slice of silicon material on a temporary backing by one of the opposite planar faces of the slice and then rotating the thus mounted slice in a lathe and successively feeding into the material at radially-spaced positions a diamond-tipped tool so as to cut into the opposite of the planar faces a succession of concentric grooves. In this case, of course, the tip of the tool will be suitably shaped to provide grooves of a proper cross-sectional shape as to form the Fresnel lens.

.As an alternative to a shaped tip of the tool, the tip can merely by pointed and, by shaping the material in a CNC lathe, movement of the tool being controlled to provide the required cross-sectional shape of the cut.

## Claims

1. A method of shaping silicon material comprising mounting the material (1) by a planar face (4) thereof on a backing (5), rotating the thus mounted material (1) about an axis (16) passing through the planar face (4), engaging the material (1) with a diamond-tipped cutting tool (20) and relatively traversing the tool (20) and the material (1) such that the tool (20) is fed into the material (1) to cut silicon from the material (1).

2. A method as claimed in Claim 1, wherein the material (1) is a wafer having therein a plurality of layers (2) of opposite-type conductivity extending parallel to the opposite planar faces (4/15) of the wafer (1) and the tool (20) is fed into the wafer (1) to cut through at least one of the p-n junctions (3) provided between the layers of opposite-type conductivity.

3. A method as claimed in Claim 2, wherein the backing (5) is a molybdenum disc.

4. A method as claimed in either Claim 2 or Claim 3, wherein the wafer (1) is mounted on the backing (5) by being soldered thereto (by 6).

5. A method as claimed in Claim 4, wherein the solder (6) is an aluminium/silicon solder.

6. A method as claimed in any one of Claims 2 to 5, wherein the axis of rotation (16) extends perpendicularly through the planar faces (4/15) of the wafer (1).

7. A method as claimed in Claim 1, wherein the material (1) has opposed planar faces by one (4/15) of which it is mounted on the backing (5) and the tool (20) is fed into the material (1) from its opposite planar face (15) to form therein a shaped groove constituting in a finished material (1) one of a number a concentric of such grooves thereby forming a Fresnel lens.

8. A method as claimed in any one of the preceding claims, wherein it is the tool (20) which is traversed relative to the material (1).

9. A method as claimed in any one of the preceding Claims, wherein the diamond of the tip of the tool (20) is of gem-stone quality or high-grade industrial quality.

10. A method as claimed in any one of the preceding Claims, wherein the tool (20) has a negative rake of less than -7 1 2 degrees.

11. A method as claimed in Claim 10, wherein the tool (20) has a negative rake of -5 degrees.

12. A method as claimed in any one of the preceding Claims, wherein the tool (20) has a clearance of less than 10 degrees.

13. A method as claimed in Claim 12, wherein the tool (20) has a clearance of +7 degrees.

14. A method as claimed in any one of the preceding claims, wherein the diamond tip of the tool (20) is shaped to the required shape of the cut (22) in the wafer (1) to be made by the tool (20).

15. A method as claimed in Claim 14, wherein the tool (20) is fed into the wafer (1) in a direction perpendicular to the planar faces (4/15) of the wafer (Fig. 2).

16. A method as claimed in Claim 15 when dependent on any one of Claims 2 to 6, wherein the tool (20) shapes the wafer (1) to form a peripheral face to the shaped wafer (1) which is conical and is of larger diameter at the planar face of the wafer (1) adjacent the backing than it is at the opposite planar face of the wafer (1).

17. A method as claimed in any one of Claims 2 to 6, wherein the tool (20) is fed into the wafer (1) in a direction inclined with respect to the axis of rotation (16) of the wafer and backing (5).

18. A method as claimed in Claim 17, wherein the tool (20) shapes the wafer (1) to form a peripheral face (22) to the shaped wafer (1) which is conical and is of smaller diameter at the planar face (4) of the wafer adjacent the backing (5) than it is at the opposite planar face (4) of the wafer.

19. A method as claimed in any one of the preceding Claims, wherein the tool (20) is fed with a water-soluble oil-solution coolant.

20. A method as claimed in any one of the preceding Claims, wherein the backing is only a temporary backing which is in place during the shaping of the material and is removed thereafter.

21. Silicon material shaped in accordance with the method as claimed in any one of the preceding claims.

FIG.1

FIG.2

FIG.3